Europäisches Patentamt

European Patent Office

Office européen des brevets

(19)

(11) Publication number: **0 360 315**
**A1**

## (12) EUROPEAN PATENT APPLICATION

(21) Application number: 89202180.9

(22) Date of filing: 29.08.89

(51) Int. Cl.5: **G11C 7/00**

(30) Priority: 31.08.88 NL 8802141

(43) Date of publication of application:
**28.03.90 Bulletin 90/13**

(84) Designated Contracting States:
**DE FR GB IT**

(71) Applicant: N.V. Philips' Gloeilampenfabrieken
Groenewoudseweg 1
NL-5621 BA Eindhoven(NL)

(72) Inventor: Pfennings, Leonardus Chritien
Matheus Giellaumes
c/o INT. OCTROOIBUREAU B.V. Prof.
Holstlaan 6
NL-5656 AA Eindhoven(NL)

(74) Representative: Faessen, Louis Marie
Hubertus et al
INTERNATIONAAL OCTROOIBUREAU B.V. 6
Prof. Holstlaan
NL-5656 AA Eindhoven(NL)

(54) **Integrated semiconductor memory circuit with dual use of bit lines.**

(57) The invention relates to an integrated semiconductor memory circuit in which memory cells are arranged in a matrix of rows and columns, which memory cells are connected to word lines and bit lines for reading and writing information in the memory cells, the bit lines extending between the memory cells being connected, via access transistors, to the memory cells which are arranged at one as well as at the other side of the bit lines, four word lines being arranged between the odd and the even rows of cells, four memory cells being connected to one node of a bit line extending between these four memory cells, the connection between said node and any memory cell connected thereto crossing a first and a second word line and extending via two series-connected access transistors, one of which is an enhancement transistor while the other access transistor is a depletion transistor, the access transistors being arranged in a two-by-two fashion so that a cell having an odd index in a row of cells is accessible by control of the enhancement transistor by a first word line, the cell having an even index in the word line direction being accessible by control of the enhancement transistors by the second word line.

FIG.1

## Integrated semiconductor memory circuit with dual use of bit lines

The invention relates to an integrated semiconductor memory circuit in which memory cells are arranged in a matrix of rows and columns, which memory cells are connected to word lines and bit lines in order to read and write information in the memory cells, the bit lines extending between the memory cells being connected, via access transistors, to the memory cells arranged at one as well as at the other side of the bit lines.

A memory circuit of this kind, to be integrated on a semiconductor substrate is described in United States Patent Specification 3,893,087. In the circuit depicted each time two word lines are shown between two rows of memory cells, one word line granting access to the odd memory cells in a row, the other word line granting access to even memory cells in a row. The electrical diagrams shown clearly indicate the connections to be established between the access transistors and the bit lines on the one side and the control electrodes of the access transistors and the word lines on the other side. The cited United States Patent Specification, however, shows only the electrical diagram and no example whatsoever is given of an actual realization of a memory thus organized. Such a layout of electrical connections, however, necessitates a large number of crossings of word lines and bit lines and crossings of word lines and the connections thereof to the control electrodes of the access transistors. Normally a large substrate surface area is required in such an integrated memory circuit for the crossings of the word lines and the connections thereof to the electrodes of the access transistors, because the word lines and the bit lines and the relevant connections must be realised in and between different layers of the integrated circuit.

It is the object of the invention to provide an integrated memory circuit of the kind set forth in which the substrate surface area required for each cell and for connecting the cell to the word lines and bit lines is minimized.

To achieve this, the integrated memory circuit in accordance with the invention is characterized in that four word lines are arranged between the odd and the even rows of cells, four memory cells being connected to one node of a bit line extending between these four memory cells, the connection between said node and any memory cell connected thereto crossing a first and a second word line and extending via two series-connected transistors, one of which is an enhancement transistor while the other transistor is a depletion transistor, the transistors being arranged in a two-by-two fashion so that a cell having an odd index in a row of cells is accessible by control of the enhancement transistor by a first word line, the cell having an even index in the word line direction being accessible by control of the enhancement transistors by the second word line. Such an arrangement of the components in a memory in accordance with the invention offers the advantage that four memory cells are connected to each contact on a bit line, so that the number of contacts is strongly reduced and the surface area required is limited. Furthermore, the problematic crossings of the word lines and the connections between the access transistors and said node are avoided by the use of the depletion transistors. This is because these depletion transistors are always conductive so that they are not blocked by the control signals on the word lines. In the connection between the memory cell and the node on the bit line, therefore, actually only one transistor is effectively present. The use of the depletion and enhancement transistors also enables the use of a very regular structure without necessitating the use of connections between polysilicon tracks and metallization tracks which would be required if no depletion transistors were used, thus enabling a reduction of the required substrate surface area and resulting in a compact construction of a memory device in accordance with the invention. If no depletion transistors are used, the crossings of word lines and bit lines would be required using polysilicon tracks and metal tracks (at different levels), the connections therebetween requiring a comparatively large amount of surface area.

The invention will be described in detail hereinafter with reference to the accompanying drawing; therein

Fig. 1 shows a circuit diagram of the memory circuit in accordance with the invention, and

Fig. 2 shows a topography of the memory circuit in accordance with the invention.

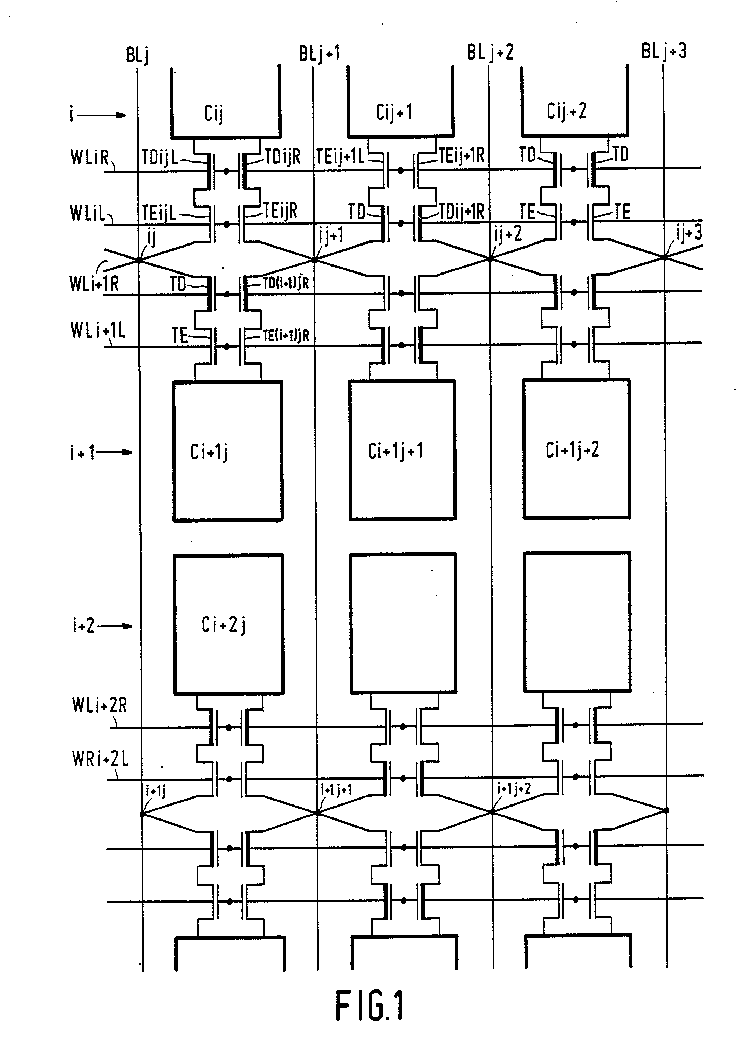

Fig. 1 shows a part of the electrical diagram of the memory device in accordance with the invention. The drawing shows some rows of memory cells i, i+2, i+3, and some cells j, j+1, j+3 in each row. The cell j in row i is connected to the node ij, via an enhancement transistor TEijL and a series-connected depletion transistor TDijL. The latter transistor is denoted by an extra heavy connection stroke. Furthermore, the memory cell Cij is connected to the node ij+1 on the bit line BLj+1. This connection extends via the enhancement transistor TEijR and the depletion transistor TDijR. The cell Cij+1 adjoining the memory cell Cij is connected to the node ij+1 on the bit line BLj+1 and the node ij+2 on the bit line BLj+2. These connections also extend via an enhancement transistor and a depletion transistor as shown in the Figure. As appears from the Figure, the sequence of the enhancement transistor and the depletion transistor is reversed for the cell Cij + 1 with respect to the sequence of these transistors for the cell Cij. Consequently, when a control signal is applied to the word line WLiR, being connected to the control electrode of the depletion transistors TDijL and TDijR and to the control electrodes of the enhancement transistors TEij + 1L and TEij + 1R, the cell Cij + 1 is connected to the nodes ij + 1 and ij + 2 because the enhancement transistors TEij + 1L, TEij + 1R are controlled so as to be conductive. The depletion transistors TD associated with the memory cell Cij + 1 are already conductive and do not require a control signal. However, the memory cell Cij is not connected to any node on the bit lines because the word line WLiL does not receive a control signal. Consequently, the enhancement transistors TEijL and TEijR are blocked so that no connection exists between the nodes ij and ij + 1 on the one side and the memory cell Cij on the other side. This Figure already demonstrates the simplicity of this lay-out of the memory device, because each time four memory cells utilize one node on a bit line, and also that the connection between the memory cells and the bit lines always extends via two transistors, resulting in a very regular structure. The use of two transistors in series for this connection does not lead to additional control signal problems because one of these two transistors is always conductive.

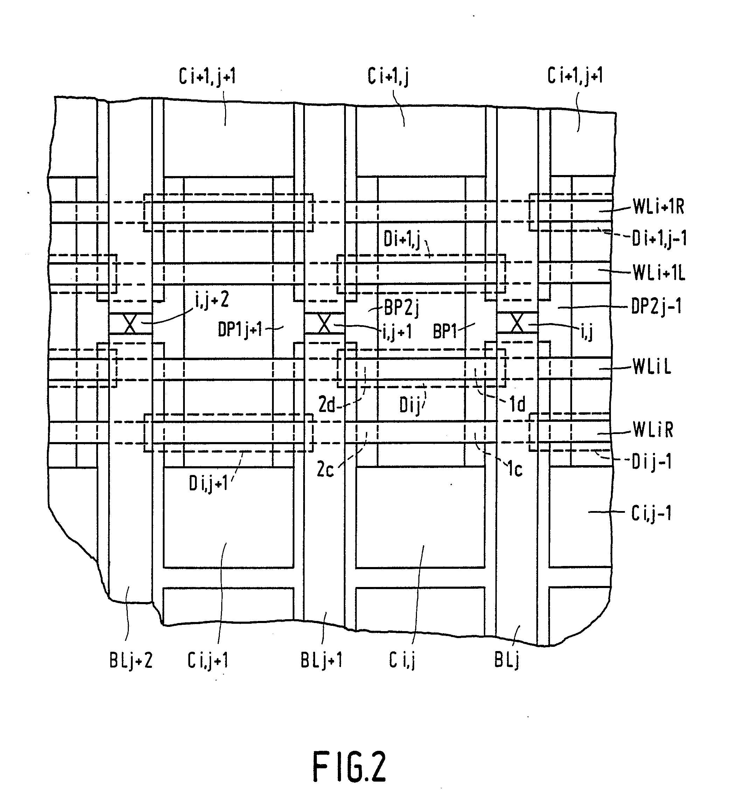

Fig. 2 shows an electrical connection diagram of an eight-transistor cell in accordance with the invention. The eight-transistor cell comprises two cross-wise coupled inverters, each of which comprises a CMOS inverter. The CMOS inverters comprise a first PMOS transistor and a second PMOS transistor and a first and a second NMOS transistor. The nodes of the transistors of a CMOS inverter are connected, via a first transistor which is an enhancement transistor in the present example, to a further depletion transistor, an electrode of which is connected to a node of a bit line. The enhancement transistors are numbered 1c and 2c, respectively, the depletion transistors being denoted by the references 1d and 2d. The depletion transistor 1d is connected to the node ij on the bit line BLj. The depletion transistor d2 is connected to the node ij + 1 of the bit line BLj + 1. The control electrodes of the enhancement transistors 1c and 2c are formed by the word line BLiR, the depletion transistors d1 and d2 being crossed by the word lines WLiL.

The lay-out shown in Fig. 2 will be described with reference to the electrical diagram and the component numbering of Fig. 1. The lay-out shown in Fig. 2 is composed of a number of successively deposited layers, the sequence of which will be briefly described hereinafter. On the semiconductor substrate there are formed diffusion regions subsequently form the semiconductor transistors in conjunction with the polysilicon tracks to be subsequently provided. After that, in a first metal layer the metal tracks are formed for the various supply voltages VDD and VSS and for the connections, if any, between the diffusions situated underneath the first metal layer and/or a second metal layer to be provided after the first metal layer. This second metal layer is used for forming the so-called bit lines, some of which are shown in the Figure, i.e. BLj, BLj + 1, BLj + 2. The polysilicon tracks which are used as the word lines WLiR, WLiL, WLi + 1R, WLi + 1L etc. are also clearly shown. The diffusions DP2j and DP1j which are used for making the transistors 2c and 2d and the transistors 1c and 1d, respectively, are connected to the nodes i, j and i, j + 1, respectively, on the bit lines Blj and BLj + 1. At the crossings of the word lines WLiR and WLiL and the diffusions shown the transistors 1c and 2c and 1d and 2d, respectively, are formed, the transistors 1c and 2c being constructed as enhancement transistors whilst the transistors 2d and 1d are constructed as depletion transistors by an additional ion implantation in a region Dij. The connection of the memory cell Cij, via the transistors 1c and 1d, to the bit line BLj extends via a contact ij of the diffusion DP2j which constitutes said transistors 1c and 1d in conjunction with the word lines WLiL and WLiR, the node i, j between four word lines WLiL, WLiR, WLi-1L and WLi-1R being situated as shown in the Figure. Similarly, the memory cell Cij is connected, via the transistors 2c and 2d, to the bit line BLj + 1 on the contact ij + 1, via the diffusion DPj + 1 which constitutes said transistors 2c and 2d in conjunction with the word lines WLi + 1L and WLi + 1R.

**Claims**

1. An integrated semiconductor memory circuit in which memory cells are arranged in a matrix of rows and columns, which memory cells are connected to word lines and bit lines in order to read and write information in the memory cells, the bit lines extending between the memory cells being connected, via access transistors, to memory cells arranged at one as well as at the other side of the bit lines, characterized in that four word lines are arranged between the odd and the even rows of cells, four memory cells being connected to one node of a bit line extending between these four memory cells, the connection between said node and any memory cell connected thereto crossing a first and a second word line and extending via two series-connected access transistors, one of which is an enhancement transistor while the other transistor is a depletion transistor, the access transistors being arranged in a two-by-two fashion so that a cell having an odd index in a row of cells is accessible by control of the enhancement transistor by a first word line, the cell having an even index in the word line direction being accessible by control of the enhancement transistors by the second word line.

2. A semiconductor memory circuit as claimed in Claim 1, in which the memory cell comprises two CMOS inverter circuits which are connected to the input and output of one another, characterized in that the two depletion access transistors for a memory cell are NMOS transistors formed in one and the same region realized by ion implantation.

FIG.1

FIG.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | US-A-3 893 087 (BAKER)<br>* Column 3, line 20 - column 8, line 26; figures 1-2 * | 1-2 | G 11 C 7/00 |
| A | IBM TECHNICAL DISCLOSURE BULLETIN, vol. 18, no. 6, November 1975, pages 1849-1850, New York, US; J.C. HSIEH: "Read and write for random-access memory array"<br>* Whole document * | 1-2 | |
| A | WO-A-8 103 571 (MOTOROLA)<br>* Page 5, line 19 - page 7, line 22; figure 2 * | 1 | |
| A | US-A-4 237 547 (SMITH)<br>* Column 3, lines 7-46; figure 2 * | 1 | |
| A | US-A-3 851 317 (KENYON)<br>* Column 2, line 33 - column 6, line 46; figures 1-2 * | 1 | TECHNICAL FIELDS SEARCHED (Int. Cl.5)<br><br>G 11 C 7/00<br>G 11 C 8/00<br>G 11 C 11/00 |

The present search report has been drawn up for all claims

| Place of search | Date of completion of the search | Examiner |
|---|---|---|
| THE HAGUE | 08-12-1989 | GEOGHEGAN C.H.B. |